## Europäisches Patentamt
## European Patent Office
## Office européen des brevets

(11) Veröffentlichungsnummer: **0 076 868**
**B1**

(12) **EUROPÄISCHE PATENTSCHRIFT**

(45) Veröffentlichungstag der Patentschrift:
14.01.87

(21) Anmeldenummer: **81108156.1**

(22) Anmeldetag: **10.10.81**

(51) Int. Cl.⁴: **H 01 J 37/302, B 41 C 1/00**

(54) **Elektronenstrahl-Gravierverfahren und Einrichtung zu seiner Durchführung.**

(43) Veröffentlichungstag der Anmeldung:
**20.04.83 Patentblatt 83/16**

(45) Bekanntmachung des Hinweises auf die Patenterteilung:
**14.01.87 Patentblatt 87/3**

(84) Benannte Vertragsstaaten:
**AT BE CH DE FR GB IT LI NL SE**

(56) Entgegenhaltungen:
**EP-A-0 029 604**
**DD-A-55 965**
**DE-A-2 111 628**
**DE-A-2 458 370**
**DE-A-3 008 176**
**DE-B-2 752 598**

(73) Patentinhaber: **DR.- ING. RUDOLF HELL GmbH, Grenzstrasse 1-5, D-2300 Kiel 14 (DE)**

(72) Erfinder: **Beisswenger, Siegfried, Albert- Einstein- Strasse 22, D-2308 Preetz (DE)**

## Beschreibung

Elektronenstrahl-Gravierverfahren und Einrichtung zu seiner Durchführung.

## Technisches Gebiet

Die vorliegende Erfindung betrifft ein Druckform-Gravierverfahren mittels Elektronenstrahlen und die Einrichtung dazu, bei dem in schneller Folge ein Raster aus näpfchenförmigen Vertiefungen, sogenannten Rasternäpfchen, durch Einwirken eines Elektronenstrahls in die Oberfläche einer Druckform, beispielsweise eines Tiefdruckzylinders hineingraviert wird.

## Zugrundeliegender Stand der Technik

Aus der DE-AS 11 23 571, der DL-PS 55 965, der DE-OS 21 11 628 und der DE-OS 24 58 370 sind bereits Verfahren zur Gravur von Druckformen mittels Elektronenstrahls bekannt, mit denen Rasternäpfchen der verschiedensten Formen hergestellt werden können. Dabei werden Intensität, Fokuslage, Energieverteilung im Strahl, Bewegung des Brennflecks und Einwirkdauer zur Erzeugung unterschiedlicher Näpfchengeometrie gesteuert.

Insbesondere die kleinvolumigen Rasternäpfchen, die beim Tiefdruck die hellen Bildpartien wiedergeben, erfordern eine hohe Konstanz bei der Herstellung. Die exakte Wiederholbarkeit einer Näpfchengeometrie in der kurzen zur Verfügung stehenden Zeit (einige µs) ist eines der schwierigsten Probleme der Elektronenstrahlgravur überhaupt.

Die Erfahrung zeigt, daß eine der Grundvoraussetzungen zur Beherrschung der lichten Töne eine tonwertabhängige Veränderung der Fokuslage auf der Druckformoberfläche fordert. Die DE-OS 24 58 370 beschreibt ein derartiges Verfahren, bei dem die Fokuslage so gesteuert wird, daß die Brennfleckebene bei kleinen Rasternäpfchen näher an der Oberfläche liegt als bei größeren. Allerdings geht das dort beschriebene Verfahren davon aus, daß der Elektronenstrahl durch ein sogenanntes Blanking-System in den Pausen zwischen der Gravur zweier aufeinanderfolgender Rasternäpfchen den dauernd eingeschalteten Elektronenstrahl von der Druckformoberfläche weglenkt.

Dieses Verfahren hat den Nachteil, daß der Elektronenstrahl nach Rückkehr auf die Druckformoberfläche gewissen Einlaufeffekten unterliegt, die die Gravur instabil machen.

Die DE-OS 29 47 444 beschreibt ein Verfahren, das den Strahl nicht mehr von der Druckformoberfläche weglenkt, sondern ihn unter Beibehaltung seiner Richtung nur mittels einer dynamischen magnetischen Linse in der Pause zwischen der Gravur zweier aufeinanderfolgender Näpfchen soweit defokussiert, daß kein Bearbeitungseffekt auf der Druckformoberfläche auftritt. Wegen der Kürze der zur Verfügung stehenden Zeit gelingt eine solche Defokussierung und Refokussierung nur mit einer zusätzlichen dynamischen Fokus-Spule, wie sie in der DE-AS 27 52 598 beschrieben ist.

Diese Spule kann natürlich auch den in der DE-OS 24 58 370 beschriebenen zur Gravur unterschiedlicher Näpfchen erforderlichen tonwertabhängigen Fokushub bewerkstelligen.

Für großvolumige Näpfchen wird dabei der engste Querschnitt des Elektronenstrahls an die Oberfläche der Druckform gelegt. Es ergibt sich eine nahezu rechteckförmige Stromverteilung über den gesamten Fleck. Für kleinvolumige Näpfchen wird der Fokus etwas über die Druckformoberfläche gelegt. Der Strahl hat nun zwar an der Oberfläche einen viel größeren Druchmesser als bei Fokussierung in der Oberfläche, jedoch ist an der Oberfläche die Leistungsdichteverteilung im Strahl ähnlich einer Gauß'schen Verteilung. Vor allem weist der zentrale "Peak" eine höhere Leistungsdichte auf, als die rechteckförmige Energieverteilung. Läßt man einen Strahl mit solcher Energiedichteverteilung nur kurzzeitig auf die Oberfläche einwirken, so entsteht durch den "Peak" in der Strahlmitte ein Näpfchen kleinen Durchmessers und kleiner Tiefe. Offensichtlich macht man sich dabei ein Schwellwertverhalten des Bearbeitungsvorgangs zu Nutze.

Die Praxis zeigt aber, daß dieses Schwellwertverhalten außerordentlich schwierig stabil zu halten ist. Geringe Drifterscheinungen in den Betriebsparametern einer Elektronenstrahlkanone, insbesondere thermische Driften, machen es unmöglich, dieses Schwellwertverhalten für die ganze Zeit der Gravur eines Tiefdruckzylinders stabil zu halten, und gerade in lichten Bildpartien (kleinen Näpfchen) ist das menschliche Auge für geringe Dichteschwankungen außerordentlich empfindlich.

## Offenbarung der Erfindung

Der vorliegenden Erfindung liegt die Aufgabe zugrunde, ein Verfahren anzugeben, daß eine langzeitkonstante Gravur aller erforderlichen Tonwerte gestattet, ohne das beschriebene instabile Schwellwertverhalten zur Tonwertbildung heranzuziehen.

Die Erfindung erreicht dies mit den im Anspruch 1 genannten Maßnahmen. Vorteilhafte Weiterbildungen sind in den Unteransprüchen angegeben.

## Kurze Beschreibung der Zeichnung

Die Erfindung wird im folgenden anhand der Figuren 1 bis 3 näher beschrieben. Es zeigen:
Figur 1: Strahlengang
Figur 2: Fokusverhältnisse bei der Gravur von großen Näpfchen.
Figur 3: Fokusverhältnisse bei der Gravur von kleinen Näpfchen.

## Bester Weg zur Ausführung der Erfindung

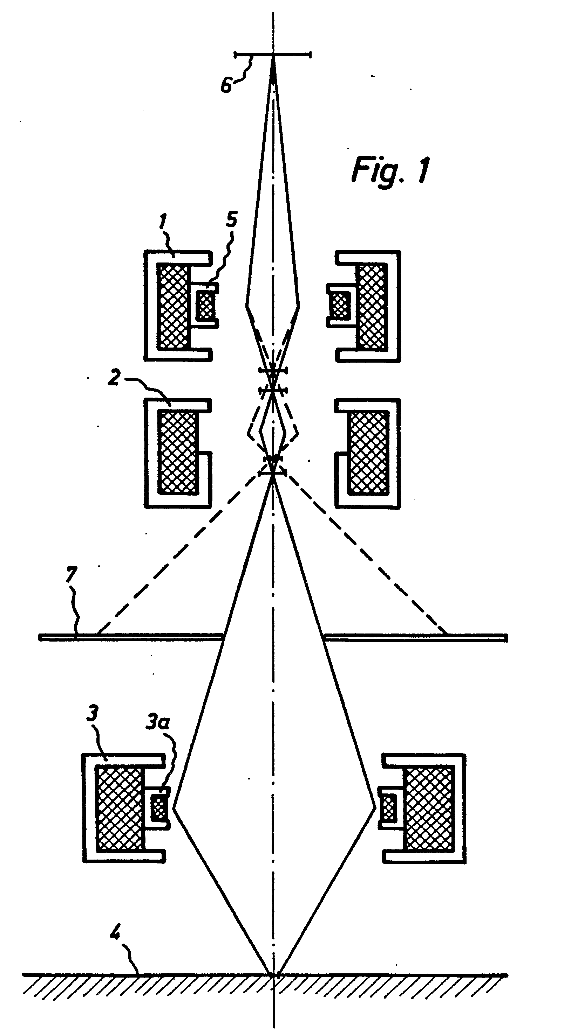

Wie Figur 1 zeigt, wird eine 3 stufige verkleinerte Abbildung der Elektronenquelle mittels magnetischer Linsen vorgenommen. Erfindungsgemäß wird zu diesem Zweck eine erste langbrennweitige Linse 1 mit einer zweiten kurzbrennweitigen Linse 2 kombiniert. Die dritte Linse 3 ist langbrennweitig und ermöglicht den großen Arbeitsabstand zur Druckformoberfläche 4; sie entspricht der Hauptlinse der bisher bekannten Elektronenstrahlkanone und ist mit einer dynamischen Linse 3a kombiniert, wie sie in der DE-AS 27 52 598 beschrieben ist. Eine ebensolche dynamische Linse 5 ist in der ersten langbrennweitigen Linse 1 angeordnet. Bei Erregung dieser Linse 5 wird die Bildweite der ersten langbrennweitigen Linse 1 um einen gerinen Betrag verändert. Der Abbildungsmaßstab der Linsenkombination 1/5 ändert sich dabei nur wenig. Da jedoch die Abbildung der Elektronenquelle 6 durch die Kombination von Linse 1 und Linse 5 das Objekt der zweiten kurzbrennweitigen Linse 2 darstellt, führt eine geringe axiale Verlagerung des ersten Zwischenbildes zu einer großen Änderung des Abbildungsmaßstabes der Linse 2. Der Abbildungsmaßstab der Linsenkombination 3/3a wird durch die Verlagerung des zweiten Zwischenbildes nur sehr wenig verändert. Der dadurch entstehende Fehler in der Fokuslage auf der Druckformoberfläche 4 kann durch Änderung der Anpassung der dynamischen Linse 3a kompensiert werden.

Ein Zahlenbeispiel möge dies verdeutlichen: Verkleinert z. B. die Linse 1 dreifach, und wird die Linse 5 in ihr nicht erregt, so kann die zweite kurzbrennweitige Linse 2 so eingestellt sein, daß sie ein Abbildungsverhältnis von 1 erzeugt. Wenn die Linse 3 dann ein Abbildungsverhältnis von 4 erzeugt, so ist die Gesamtverkleinerung gleich 12. In Figur 1 ist der sich ergebende Strahlengangmit durchgezogenen Linien dargestellt. Wird nun die in Linse 1 angeordnete Linse 5 erregt, so rückt das erste Zwischenbild näher auf die Linsenkombination 1/5 zu. Gleichzeitig wird die Objektweite der zweiten kurzbrennweitigen Linse 2 größer. Dies bedeutet, daß die kurzbrennweitige Linse 2 nun bei unveränderter Erregung einen Abbildungsmaßstab von beispielsweise 3 aufweist. Der Gesamtverkleinerungsmaßstab der Anordnung hat sich somit auf 36 verändert. Der sich ergebende Strahlengang ist in Figur 1 gestrichelt dargestellt.

Wird hinter der kurzbrennweitigen Linse 2 eine Aperturblende 7 angeordnet, so kommt es zusätzlich zur Modulation des Abbildungsmaßstabes auch zu einer Modulation der Strahlenergie.

Dadurch ist es möglich, sowohl kleine wie große Näpfchen mit etwa gleicher Leistungsdichte zu garantieren.

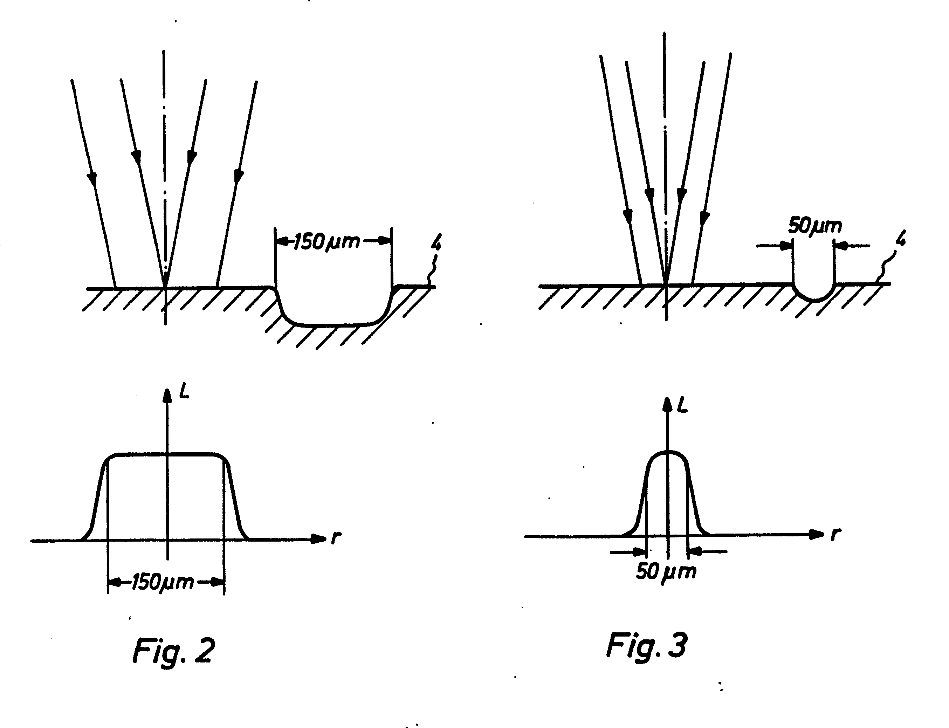

Die Fokusverhältnisse am Wirkpunkt des Strahls sind für große Näpfchen in Figur 2, für kleine Näpfchen in Figur 3 dargestellt. L bezeichnet die Strahlleistungsdichte und r bezeichnet den Radius am Einwirkpunkt.-Um eine Vorstellung von den Dimensionen zu geben, sind in Figur 2 und 3 einige Maße als Anhalt eingetragen.

Die beschriebene Anordnung ermöglicht eine sehr schnelle Änderung des Abbildungsmaßstabes. Die Einstellzeit beim übergang von starker zu schwacher Verkleinerung und umgekehrt läßt sich mit der erfindungsgemäßen Anordnung in ca. 1 μs durchführen.

Die Erregung der Linse 5 liegt in der gleichen Größenordnung, wie sie auch für das in der DE-OS 29 47 444 beschriebene Unscharftasten des Strahls in der Gravurpause zwischen zwei aufeinanderfolgenden Näpfchen erforderlich ist.

## Gewerbliche Verwertbarkeit

Die Erfindung kann mit Vorteil bei der Gravur von Druckformen mit Elektronenstrahlen verwendet werden. Sie kann auch überall da eingesetzt werden, wo Materialbearbeitung irgendwelcher Art wie Schweißen, Bohren, Gravieren, Erhitzen usw. mit Ladungsträgerstrahlen ausgeführt wird. Darüber hinaus kann sie auch auf dem Gebiet der Elektronenstrahl-Lithographie Anwendung finden.

## Patentansprüche

1. Elektronenstrahl-Gravierverfahren zum Erzeugen von Rasternäpfchen unterschiedlicher Abmessunü gen in einer Druckformoberfläche, bei welchem die Rasternäpfchen durch Einwirkung eines ständig auf die Oberfläche gerichteten defokussierbaren Elektronenstrahls zustande kommen, der in Arbeitsstellung in oder unmittelbar in der Umgebung der Oberfläche fokussiert ist, dadurch gekennzeichnet, daß außer der Einwirkdauer und der Fokuslage gleichzeitig der Abbildungsmaßstab der Ladungsträgerquelle auf der Druckformoberfläche (4) tonwertabhängig gesteuert wird.

2. Verfahren nach Anspruch 1, <u>dadurch gekennzeichnet</u>, daß große Rasternäpfchen mit mäßiger, kleine Rasternäpfchen mit starker elektronenoptischer Verkleinerung der Ladungsträgerquelle hergestellt werden.

3. Verfahren nach Anspruch 1 bis 3, <u>dadurch gekennzeichnet</u>, daß sowohl für große wie für kleine Rasternäpfchen die Leistungsdichteverteilung im Strahl nahezu rechteckförmig ist.

4. Verfahren nach Anspruch 1, <u>dadurch gekennzeichnet</u>, daß außer dem Abbildungsmaßstab auch die Leistungsdichteverteilung im Strahl tonwertabhängig gesteuert wird.

5. Elektronenstrahlkanone mit einem dreistufigen Linsensystem zur Durchführung des Verfahrens nach einem der Ansprüche 1 bis 4, <u>dadurch gekennzeichnet</u>, daß in Strahlrichtung gesehen hintereinander angeordnet sind: eine erste, langbrennweitige Linse (1), in der eine erste dynamische Linse (5) angeordnet ist; eine zweite, kurzbrennweitige Linse (2); eine dritte, langbrennweitige Linse (3), in der eine zweite dynamische Linse (3a) angeordnet ist; wobei die Erregung der ersten dynamischen Linse (5) tonwertabhängig veränderbar ist.

6. Elektronenstrahlkanone nach Anspruch 5, <u>dadurch gekennzeichnet</u>, daß zwischen der zweiten kurzbrennweitigen Linse (2) und der dritten langbrennweitigen Linse (3) eine Aperturblende (7) angeordnet ist.

## Claims

1. Electron beam engraving process for producing screen pinholes of different size in a printing block surface, in which the screen pinholes are produced by the action of a defocussable electron beam aimed at the surface, which in the operative position is focussed on or in the immediate vicinity of the surface, characterised in that apart from the period of action and the focus location, the scale of reproduction of the charge carrier source on the printing block surface (4) is controlled at the same time as a function of tonal value.

2. Process according to claim 1, characterised in that large screen pinholes are produced with a moderate electron-optical reduction of the charge carrier source, small screen pinholes being produced by a large electron-optical reduction of the same.

3. Process according to claims 1 to 3, characterised in that the energy density distribution in the beam is almost rectangular for large as well as small screen pinholes.

4. Process according to claim 1, characterised in that apart from the scale of reproduction, the energy density distribution in the beam is also controlled as a function of tonal value.

5. Electron beam gun comprising a three-stage lens system for application of the process according to one of the claims 1 to 4, characterised in that the following are arranged one behind the another as seen in the direction of the beam:.

a first lens (1) of long focal length, wherein is situated a first dynamic lens (5);

a second lens (2) of short focal length;

a third lens (3) of long focal length, wherein is situated a second dynamic lens (3a); the energisation of the first dynamic lens (5) being variable as a function of tonal value.

6. Electron beam gun according to claim 5, characterised in that an aperture stop or diaphragm (7) is situated between the second short focal length lens (2) and the third long focal length lens (3).

## Revendications

1°) Procédé de gravure par faisceau d'éléctrons pour former les petites cavités d'une trame, ayant des dimensions différentes à la surface d'une matrice d'impression, procédé selon lequel on forme les cavités de la trame par effet d'un faisceau d'électrons susceptible d'être défocalise, et qui est dirige en permanence sur la surface superficielle, faisceau qui en position de travail est focalisé sur ou directement au voisinage de la surface supérieure, caractérisé en ce qu'en plus de la durée d'action et de la position du foyer, on commande en même temps l'échelle de l'image de la source de porteurs de charge à la surface supérieure (4) de la matrice d'impression, en fonction de la valeur de la teinte.

2°) Procédé selon la revendication 1, caractérisé en ce qu'on réalise de grandes cavités de trame avec des petites cavités de trame, moyennes, par une forte réduction optoélectronique de la source de porteurs de charge.

3°) Procédé selon les revendications 1 et 2, caractérisé en ce qu'à la fois pour de grandes cavités de trame que pour de petites cavités de trame, la répartition de la densité de puissance du faisceau est pratiquement rectangulaire.

4°) Procédé selon la revendication 1, caractérisé en ce qu'on commande non seulement l'échelle de l'image mais également la répartition de la densité de puissance du faisceau en fonction de la valeur de la teinte.

5°) Canon à faisceau d'électrons comportant un système de lentilles à trois étages pour la mise en oeuvre du procédé selon l'une des revendications 1 à 4, caractérisé en ce qu'on a successivement dans la direction du faisceau: - une première lentille (1) à grande distance focale dans laquelle il est prévu une première lentille dynamique (5); - une seconde lentille (2) à courte distance focale; - une troisième lentille (3) à grande distance focale qui comporte une seconde lentille dynamique (3a); l'excitation de la première lentille dynamique (5) pouvant être modifiee en fonction de la valeur de la teinte.

6°) Canon à faisceau d'électrons selon la revendication 5, caractérisé en ce qu'il est prévu un diaphragme (7) entre la seconde lentille (2) à courte distance focale et la troisième lentille (3) à grande distance focale.

0 076 868

Fig. 1

*Fig. 2*

*Fig. 3*